# EUROPEAN PATENT APPLICATION

(11) **EP 0 772 301 A2**
(43) Date of publication of application: **07.05.1997**
(21) Application number: 96117258.2
(22) Date of filing: 28.10.1996
(51) Int. Cl.: H03K 19/00, H03K 19/003, H03K 19/094

(54) **Circuit for stabilizing the output of a tri-state circuit**

(30) Priority: 03.11.1995 KR 3960895
(71) Applicant: SAMSUNG ELECTRONICS CO., LTD., Suwon-city, Kyungki-do 441-373 (KR)
(72) Inventor: Choi, Hwa-Il, Saha-gu, Busankwangyeok-City (KR)
(74) Representative: Tunstall, Christopher Stephen

(57) **Abstract**

A stabilizing circuit for stabilizing the output of a tri-state circuit is described. The tri-state circuit has at least two input terminals N1, N2 for receiving at least two input signals and an output terminal INA which enters a high impedance state when the input signals are different. The stabilizing circuit comprises an XOR gate for XORing the input signals and provide a HIGH output signal when the input signals are different and a LOW output otherwise. A PMOS transistor PMN pulls the output terminal INA of the tri-state circuit down to ground potential Vss if the output signal is HIGH, i.e. the terminal INA would otherwise be floating. Thus, it is possible to remove the floating state of the output node INA and to isolate unwanted current paths.

## Description

### Background to the Invention

The present invention relates to a circuit for stabilizing the output of a tri-state circuit, and more particularly to circuits which can stabilize the output of the tri-state circuit whilst removing unwanted current paths.

Generally, CMOS logic devices have a high impedance state which is caused by timing mismatch during dynamic operation and by a delay value. Such a high impedance state causes unstable operation of the device, sometimes resulting in malfunction of the device.

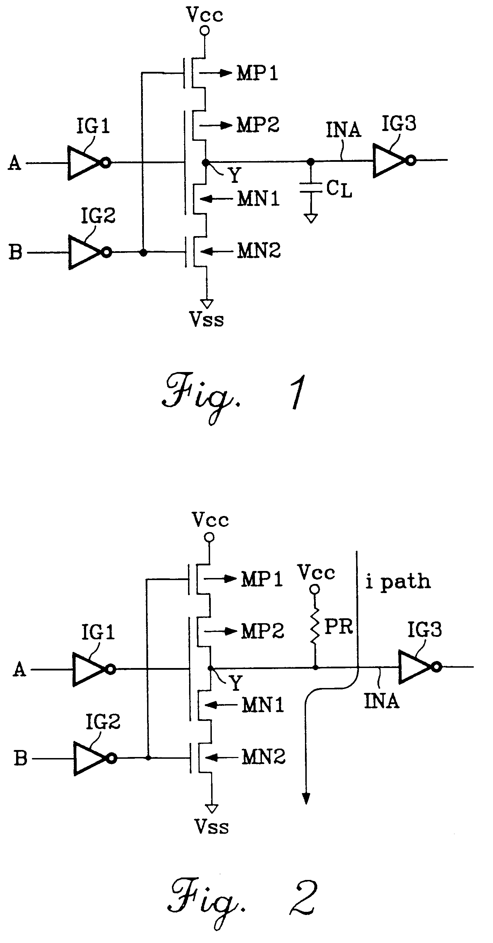

Fig. 1 shows the construction of a typical tri-state circuit. Referring to Fig. 1, if two input signals A and B have identical logic levels, this circuit outputs a logic "low" signal or a logic "high" signal according to the logic states of the input signals. That is, if the input signals A and B are both at the logic "low" level, these signals are inverted to logic "high" levels via inverters IG1 and IG2. Then, PMOS transistors MP1 and MP2 are turned off, while NMOS transistors MN1 and MN2 are turned on. Thus, the output signal Y of the tri-state circuit goes to the logic "low" level. If the input signals A and B are both at the logic "high" level, the output signal Y goes to the logic "high" level.

However, if the logic levels of the input signals A and B are different from each other, i.e. A=0 & B=1 or A=1 & B=0, the tri-state circuit enters a floating state. That is, if the input signal A=0 and the input signal B=1, these signals A and B are inverted to logic "high" and "low" levels, respectively, via the inverters IG1 and IG2. Thus, the PMOS transistor MP1 and NMOS transistor MN1 are turned on and the PMOS transistor MP2 and NMOS transistor MN2 are turned off. Therefore, the output signal Y of the tri-state circuit enters the high impedance or floating state. This is also true for the case that A=1 and B=0.

Hence, the operation of the tri-state circuit as shown in Fig. 1 can be explained by the following Table 1.

**Table 1**

| Node | Case 1 | Case 2 | Case 3 | Case 4 |
|---|---|---|---|---|
| A | 0 | 0 | 1 | 1 |
| B | 0 | 1 | 0 | 1 |
| Y | 0 | Z | Z | 1 |
| INA | L | Float | Float | H |

Therefore, if the two input signals of the tri-state circuit as shown in Fig. 1 have different logic levels from each other, the output node enters a floating state. In this case, if the capacity of the load capacitor C_{L} cannot sufficiently drive the following stage, this may cause the malfunction of the circuit. To prevent such a malfunction, the floating state can be prevented by adding a pull-up circuit or a pull-down circuit as shown in Fig. 2.

Referring to Fig. 2, if two input signals A and B have different logic levels from each other, e.g. A=0 & B=1 or A=1 & B=0, the tri-state circuit enters the floating state as described above. That is, if A=0 and B=1, these input signals are inverted to the logic "high" and "low" levels via the inverters IG1 and IG2, respectively. Thus, the PMOS transistor MP1 and NMOS transistor MN1 are turned on and the PMOS transistor MP2 and NMOS transistor MN2 are turned off. Thus, the output signal Y of the tri-state circuit enters the floating state. However, the output node INA is maintained at the power supply voltage Vcc level by the pull-up resistor PR connected between the output node INA and the power supply voltage Vcc. Therefore, the output of the tri-state circuit goes to the logic "high" state and thus can be prevented from floating. This is also true for the case that A=1 and B=0.

However, if the input signals A and B are at the logic "low" level, these signals are inverted to the logic "high" level via the inverters IG1 and IG2, respectively. Thus, the PMOS transistors MP1 and MP2 are turned off and the NMOS transistors MN1 and MN2 are turned on. Thus, the output signal Y of the tri-state circuit goes to the logic "low" state. Then, the power supply voltage Vcc is connected to a ground terminal via the pull-up resistor PR and the NMOS transistors MN1 and MN2. Thus, there is formed a current path at the output node INA, causing unnecessary current consumption.

Fig. 2 shows a conventional circuit for stabilizing the output of the tri-state circuit as shown in Fig. 1 by using a pull-up method, however, it is also possible to prevent the floating by using a pull-down method in a similar way as described above. In the circuit for stabilizing the output of the tri-state circuit using the pull-up method as described above, an unnecessary current path is formed when the output signal Y is at the logic "low" level, whilst in the circuit for stabilizing the output of the tri-state circuit using the pull-down method, an unnecessary current path is formed when the output signal Y is at the logic "high" level.

Hence, the operation of the tri-state circuit using the pull-up method can be explained by the following Table 2, and the operation of the tri-state circuit using the pull-down method can be explained by the following Table 3.

**Table 2**

| (Pull-up Method) | | | | |
|---|---|---|---|---|
| Node | Case 1 | Case 2 | Case 3 | Case 4 |
| A | 0 | 0 | 1 | 1 |
| B | 0 | 1 | 0 | 1 |
| Y | 0 | X | X | 1 |
| INA | L | H | H | H |
| Current path | Yes | No | No | No |

**Table 3**

| (Pull-down Method) | | | | |
|---|---|---|---|---|
| Node | Case 1 | Case 2 | Case 3 | Case 4 |
| A | 0 | 0 | 1 | 1 |
| B | 0 | 1 | 0 | 1 |
| Y | 0 | X | X | 1 |
| INA | L | L | L | H |
| Current path | No | No | No | Yes |

Therefore, when using the pull-up or pull-down method to prevent the tri-state circuit from floating, there remains the problem of increased power consumption due to the unnecessary current path as described above.

It is therefore an object of the present invention to provide a circuit which can prevent the floating node in a high impedance circuit, while reducing power consumption.

It is another object of the present invention to provide a circuit which can reduce the power consumption by removing an unnecessary current path in a tri-state circuit where the floating node is prevented by using a pull-up or pull-down method.

### Summary of the Invention

To achieve the above objects, the present invention provides a stabilizing circuit for stabilizing the output of a tri-state circuit which has at least two input terminals for receiving at least two input signals and an output terminal which enters a high impedance state when the input signals take on a given combination or one of a number of given combinations, the stabilizing circuit comprising:
a logic circuit having at least two input terminals for receiving the said input signals and adapted to provide an output signal of a first class when the input signals take on the said given combination or one of the said number of given combinations and of a second class otherwise;
means for pulling the output terminal of the tri-state circuit up or down to a predetermined voltage level if the output signal is of the said first class.

Preferably, the output signal is a single output line and the first and second class of signals are first and second logic levels. The means for pulling the output terminal of the tri-state circuit up or down may comprise a MOS transistor having its channel connected between the output terminal and the said predetermined voltage level and its gate connected to the said output line.

Preferably, the second input signal is a control signal and the output terminal enters a high impedance state when the first input signal and the control signal are at different logic logic levels. The said logic circuit may be an XOR or an XNOR circuit.

In one embodiment of the present invention, the said logic circuit is an XOR circuit and the means for pulling the output terminal of the tri-state circuit up or down comprises an NMOS transistor having its channel connected between the output terminal and the said predetermined voltage level and its gate connected to the said output line. The said predetermined voltage may be ground potential.

In another embodiment of the present invention, the said logic circuit is an XNOR circuit and the means for pulling the output terminal of the tri-state circuit up or down comprises a PMOS transistor having its channel connected between the output terminal and the said predetermined voltage level and its gate connected to the said output line. The said predetermined voltage may be a power supply voltage level.

The present invention also extends to a tri-state circuit having at least two input terminals for receiving at least two input signals and an output terminal which enters a high impedance state when the input signals take on a given combination or one of a number of given combinations provided with a stabilizing circuit according to any preceding claim for stabilizing its output.

The tri-state circuit may comprise:
a buffer circuit connected between the first input terminal and the output terminal and comprising a first PMOS transistor and a first NMOS transistor; and
a control circuit comprising a second PMOS transistor connected between a second voltage and the source of the first PMOS transistor and a second NMOS transistor connected between the source of the first NMOS transistor and a first voltage, the gates of the second PMOS and NMOS transistors being connected to the second input terminal. The first voltage may be a power supply voltage and the second voltage may be ground potential.

### Brief Description of the Drawings

The present invention will now be described by way of example with reference to the accompanying drawings in which:
Fig. 1 shows the construction of a typical tri-state circuit;
Fig. 2 shows a conventional circuit for stabilizing the output of the tri-state circuit of Fig. 1;
Fig. 3 shows a circuit for stabilizing the output of the tri-state circuit of Fig. 1 according to one embodiment of the present invention; and
Fig. 4 shows a circuit for stabilizing the output of the tri-state circuit of Fig. 1 according to another embodiment of the present invention.

### Detailed Description of the Preferred Embodiments

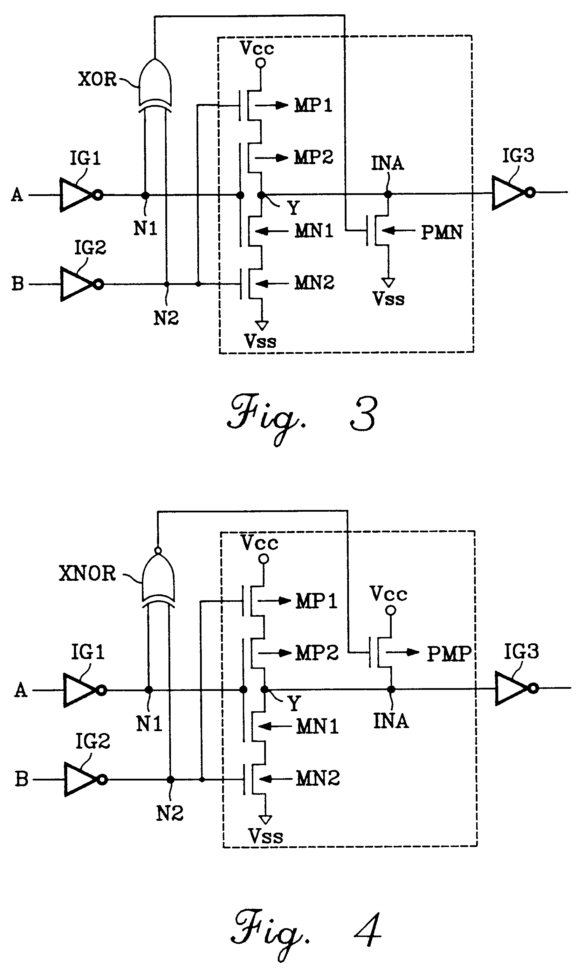

Fig. 3 is a circuit diagram showing a circuit for stabilizing the output of a tri-state circuit using a pull-down method according to the present invention. Referring to Fig. 3, first and second input signals A and B are inverted via inverters IG1 and 1G2 and then are applied to first and second input nodes N1 and N2, respectively. In this case, the second input signal B is used as a control signal. The tri-state circuit comprises a buffer circuit with an inverter construction and a control circuit. The buffer circuit comprising a PMOS transistor MP2 and an NMOS transistor MN1 is connected between the first input node N1 and an output node INA. The control circuit comprises a PMOS transistor MP1 connected between a power supply voltage Vcc and the source of the PMOS transistor MP2 and an NMOS transistor MN2 connected between the source of the NMOS transistor MN1 and a ground voltage Vss. The gates of the PMOS transistor MP1 and NMOS transistor MN2 are connected to the second input node N2. A pull-down transistor PMN is connected between the output node INA and ground potential Vss and has a gate connected to the output of an exclusive OR gate XOR. The exclusive OR gate XOR exclusively ORs two inverted input signals $\overline{\text{A}}$ and $\overline{\text{B}}$ and then applies the result to the gate of the pull-down transistor PMN.

Referring to the operation of the tri-state circuit as shown in Fig. 3, if two input signals A and B have different logic levels to each other, e.g. A=0 & B=1 or A=1 & B=0, the pull-down transistor PMN operates, thus preventing the floating state. That is, if A=0 and B=1, these signals are inverted to the logic "high" and "low" levels via the inverters IG1 and IG2, respectively. Thus, the PMOS transistor MP1 and NMOS transistor MN1 are turned on and the PMOS transistor MP2 and NMOS transistor MN2 are turned off. Thus, the output signal Y of the tri-state circuit enters the floating state. However, since the exclusive OR gate XOR connected to the first and second input nodes N1 and N2 receives two different levels of input signals, the exclusive OR gate XOR outputs a logic "high" signal to the gate of the pull-down transistor PMN. Then, the pull-down transistor PMN is turned on, thus pulling the level of the output node INA down to the ground voltage Vss level. Thus, the floating state of the tri-state circuit changes to the logic "low" state. This is true for the case that A=1 and B=0.

However, if these two input signals A and B are both logic "high" signals, these signals are inverted to the logic "low" levels via the inverters IG1 and IG2, respectively, thereby turning on the PMOS transistors MP1 and MP2 and turning off the NMOS transistors MN1 and MN2. The exclusive OR gate XOR inputs two input signals $\overline{\text{A}}$ and $\overline{\text{B}}$ which have an identical logic level, thus outputting the logic "low" signal to the gate of pull-down transistor PMN. Thus, the pull-down transistor PMN is turned off, isolating the path between the output node INA and the ground voltage Vss. In the circuit for stabilizing the output of the tri-state circuit by using the pull-down method, when the logic "high" signal is output from the output node INA, the pull-down transistor PMN is turned off by the output of the exclusive OR gate XOR, thus enabling the isolation of the current path.

The operation of the tri-state circuit as shown in Fig. 3 can be explained by the following Table 4.

**Table 4**

| (Pull-down Method) | | | | |
|---|---|---|---|---|
| Node | Case 1 | Case 2 | Case 3 | Case 4 |
| A | 0 | 0 | 1 | 1 |
| B | 0 | 1 | 0 | 1 |
| Y | 0 | X | X | 1 |
| INA | L | L | L | H |
| Current path | No | No | No | No |

Fig. 4 shows a circuit for stabilizing the output of the tri-state circuit using the pull-up method according to the present invention. First and second input signals A and B are inverted via inverters IG1 and IG2 and then applied to first and second input nodes N1 and N2, respectively. The tri-state circuit comprises a buffer circuit with an inverter construction and a control circuit. The buffer circuit comprising a PMOS transistor MP2 and an NMOS transistor MN1 is connected to the first input node N1. The control circuit comprises a PMOS transistor MP1 connected between the power supply voltage Vcc and the source of the PMOS transistor MP2 and an NMOS transistor MN2 connected between the source of the NMOS transistor MN1 and ground potential Vss. The gates of the PMOS transistor MP1 and NMOS transistor MN2 are connected to the second input node N2. A pull-up transistor PMP is connected between the power supply voltage Vcc and the output node INA and has a gate connected to the output terminal of an exclusive NOR gate XNOR. The exclusive NOR gate XNOR exclusively NORs two input signals $\overline{\text{A}}$ and $\overline{\text{B}}$ from the first and second input nodes N1 and N2 and then applies the result to the gate of the pull-up transistor PMP.

Referring to the operation of the tri-state circuit as shown in Fig. 4, if the levels of the two input signals A and B are different to each other e.g. A=0 & B=1 or A=1 & B=0, the pull-up transistor PMP operates, thus preventing the tri-state circuit from floating. That is, if A = 0 and B = 1, these signals are inverted to the logic "high" and "low" levels via the inverters IG1 and IG2, respectively, thereby turning on the PMOS transistor MP1 and NMOS transistor MN1 and turning off the PMOS transistor MP2 and NMOS transistor MN2. Thus, the output signal Y of the tri-state circuit enters the floating state. However, since the exclusive NOR gate XNOR receives two different levels of input signals, the exclusive NOR gate XNOR outputs the logic "low" signal to the gate of the pull-up transistor PMP. Thus, the pull-up transistor PMP is turned on and the output node INA changes to the logic "high" of power supply voltage Vcc level. Thus, the tri-state circuit changes from the floating state to the logic "high" state. This is also true for the case that A=1 and B=0.

However, if two input signals A and B are both logic "low" signals, these signals are inverted to the logic "high" levels via the inverters IG1 and IG2, respectively, thereby turning off the PMOS transistors MP1 and MP2 and turning on the NMOS transistors MN1 and MN2. The exclusive NOR gate XNOR receives two input signals which have an identical logic level, thus outputting a logic "high" signal to the gate of the pull-up transistor PMP. Thus, the pull-up transistor PMP is turned off, isolating the path between the power supply voltage Vcc and the output node INA. In the circuit for stabilizing the output of the tri-state circuit using the pull-up method, in the case that the logic "low" signal is output from the output node INA, the pull-up transistor PMP is turned off by the exclusive NOR gate XNOR, thus enabling the isolation of the current path.

The operation of the tri-state circuit as shown in Fig. 4 can be explained by the following Table 5.

**Table 5**

| (Pull-up Method) | | | | |
|---|---|---|---|---|
| Node | Case 1 | Case 2 | Case 3 | Case 4 |
| A | 0 | 0 | 1 | 1 |
| B | 0 | 1 | 0 | 1 |
| Y | 0 | X | X | 1 |
| INA | L | H | H | H |
| Current path | No | No | No | No |

As described above with reference to Figs. 3 and 4, it is possible to remove the floating state of the output node INA and to isolate the current path using a combined circuit, e.g. the exclusive OR gate XOR and pull-down transistor PMN or the exclusive NOR gate XNOR and pull-up transistor PMP. This enables a considerable reduction of power consumption. Therefore, the circuit for stabilizing the output of the tri-state circuit according to the present invention can stabilize the operation of the tri-state circuit by preventing the floating state and can isolate unnecessary current paths, thus reducing power consumption.

## Claims

1. A stabilizing circuit for stabilizing the output of a tri-state circuit which has at least two input terminals for receiving at least two input signals and an output terminal which enters a high impedance state when the input signals take on a given combination or one of a number of given combinations, the stabilizing circuit comprising:
a logic circuit having at least two input terminals for receiving the said input signals and adapted to provide an output signal of a first class when the input signals take on the said given combination or one of the said number of given combinations and of a second class otherwise;
means for pulling the output terminal of the tri-state circuit up or down to a predetermined voltage level if the output signal is of the said first class.

2. A circuit according to claim 1 in which the output signal is a single output line and the first and second class of signals are first and second logic levels.

3. A circuit according to claim 2 in which the means for pulling the output terminal of the tri-state circuit up or down comprises a MOS transistor having its channel connected between the output terminal and the said predetermined voltage level and its gate connected to the said output line.

4. A circuit according to any preceding claim in which the second input signal is a control signal and the output terminal enters a high impedance state when the first input signal and the control signal are at different logic levels.

5. A circuit according to claim 4 in which the said logic circuit is an XOR or an XNOR circuit.

6. A circuit according to claim 5 in which the said logic circuit is an XOR circuit and the means for pulling the output terminal of the tri-state circuit up or down comprises an NMOS transistor having its channel connected between the output terminal and the said predetermined voltage level and its gate connected to the said output line.

7. A circuit according to claim 6 in which the said predetermined voltage is ground potential.

8. A circuit according to claim 5 in which the said logic circuit is an XNOR circuit and the means for pulling the output terminal of the tri-state circuit up or down comprises a PMOS transistor having its channel connected between the output terminal and the said predetermined voltage level and its gate connected to the said output line.

9. A circuit according to claim 8 in which the said predetermined voltage is a power supply voltage level.

10. A tri-state circuit having at least two input terminals for receiving at least two input signals and an output terminal which enters a high impedance state when the input signals take on a given combination or one of a number of given combinations provided with a stabilizing circuit according to any preceding claim for stabilizing its output.

11. A circuit according to claim 10 in which the tri-state circuit comprises:
a buffer circuit connected between the first input terminal and the output terminal and comprising a first PMOS transistor and a first NMOS transistor; and
a control circuit comprising a second PMOS transistor connected between a second voltage and the source of the first PMOS transistor and a second NMOS transistor connected between the source of the first NMOS transistor and a first voltage, the gates of the second PMOS and NMOS transistors being connected to the second input terminal.

12. A circuit according to claim 11 in which the first voltage is a power supply voltage and the second voltage is ground potential.

13. A stabilizing circuit for stabilizing the output of a tri-state circuit as described with reference to and as illustrated in FIGs. 3 and 4 of the accompanying drawings.

14. A tri-state circuit as described with reference to and as illustrated in FIGs. 3 and 4 of the accompanying drawings, provided with a stabilizing circuit according to any one of claims 1-9 and 13.
